# EUROPEAN PATENT APPLICATION

(11) **EP 4 739 082 A2**
(43) Date of publication of application: **06.05.2026**
(21) Application number: 25211304.8
(22) Date of filing: 27.10.2025
(51) Int. Cl.: H10W 74/01, H10W 74/10, H10W 72/00

(54) **WAFER-LEVEL CHIP-SCALE SEMICONDUCTOR DEVICE AND METHOD THEREFOR**

(30) Priority: 31.10.2024 US 202418932731
(71) Applicant: NXP B.V., 5656 AG Eindhoven (NL)
(72) Inventor: Tien, Yujen, 5656AG Eindhoven (NL); Huang, Wen Hung, 5656AG Eindhoven (NL); Mao, Kuan-Hsiang, 5656AG Eindhoven (NL); Liu, Yufu, 5656AG Eindhoven (NL)
(74) Representative: Colaiuda, Antonella

(57) **Abstract**

A method of forming a semiconductor device is provided. The method includes applying a first non-conductive layer onto an active side of a semiconductor wafer having a plurality of semiconductor die surrounded by singulation lanes. A trench is formed in the singulation lanes surrounding the semiconductor die and filled with a non-conductive filler. A backside of the semiconductor wafer is ground to expose the non-conductive filler through the backside of the semiconductor wafer. A second non-conductive layer is applied onto the backside of the semiconductor wafer. A singulation cut is formed through a portion of the non-conductive filler to form a plurality of individual packaged semiconductor device units. A predetermined portion of the non-conductive filler remains on each sidewall of the plurality of semiconductor die.

## Description

### Background

### Field

This disclosure relates generally to semiconductor device packaging, and more specifically, to a wafer-level chip-scale semiconductor device and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified dimensional view, an example wafer-level chip-scale semiconductor device at a stage of manufacture in accordance with an embodiment.
FIG. 2 through FIG. 7 illustrate, in simplified cross-sectional views, the example semiconductor device at stages of manufacture in accordance with an embodiment.
FIG. 8 illustrates, in a simplified dimensional view, the example semiconductor device at a subsequent stage of manufacture in accordance with an embodiment.
FIG. 9 through FIG. 11 illustrate, in simplified cross-sectional views, the example semiconductor device at subsequent stages of manufacture in accordance with an embodiment.

### Detailed Description

Generally, there is provided, a wafer-level chip-scale semiconductor device having six-sided die protection. A first non-conductive layer is bonded on an active side of a semiconductor wafer containing a plurality of die surrounded by singulation lanes. A redistribution structure is formed over the first non-conductive layer and interconnected with bond pads of the die through openings formed in the first non-conductive layer. A continuous trench is formed along the singulation lanes such that each die is surrounded by the trench. The trench is subsequently filled with a filler material such as an epoxy compound or glass material. After the trench is filled, the backside of the semiconductor wafer is subjected to a grind operation to reduce the wafer thickness and expose the filler material through the backside of the wafer. A second non-conductive layer is bonded on the ground backside of the semiconductor wafer and exposed filler surface. A sandwich-like structure is formed with the semiconductor wafer sandwiched between the first non-conductive layer and the second non-conductive layer. After the second non-conductive layer is bonded on the backside of the semiconductor wafer, the sandwich-like structure is singulated to form a plurality of individual semiconductor device units. The singulation cut is formed having a width narrower than the width of the trench such that a filler coating portion remains on the sidewalls of each die after singulation. By forming the semiconductor device in this manner, a substantially thin, low-cost semiconductor device having six-sided die protection may be realized.

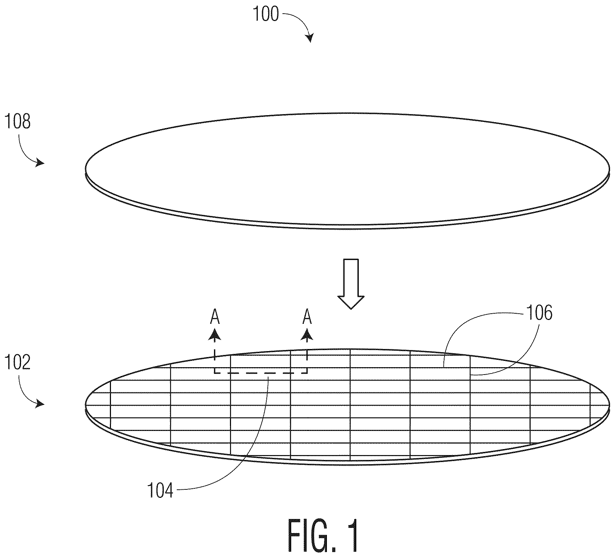

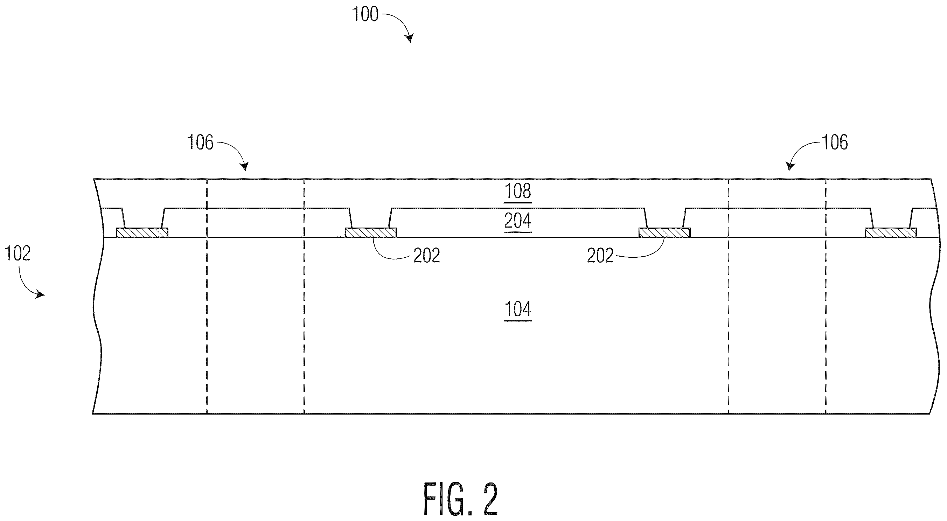

FIG. 1 illustrates, in simplified dimensional view, an example wafer-level chip-scale semiconductor device 100 at a stage of manufacture in accordance with an embodiment. At this stage, a first non-conductive layer 108 is positioned over a semiconductor wafer 102. The non-conductive layer 108 may be provided as a preformed dry dielectric film such as Ajinomoto Build-up Film (ABF), for example. In this embodiment, the semiconductor wafer 102 is arranged in an active-side-up orientation and configured for the non-conductive layer 108 to be bonded at the active side during a subsequent stage of manufacture. The term "conductive," as used herein, generally refers to electrical conductivity unless otherwise described. Simplified cross-sectional views of the example semiconductor device 100 taken along line A-A at stages of manufacture are depicted in FIG. 2 through FIG. 7 and FIG. 9 through FIG. 11.

The semiconductor wafer 102 includes a plurality of (pre-singulated) semiconductor die 104 surrounded by singulation lanes 106. The semiconductor wafer 102 has the active side (e.g., major side having circuitry) and a backside (e.g., major side opposite of the active side). The semiconductor die 104 includes bond pads (not shown) formed at the active side, for example. The semiconductor wafer 102 may be formed from any suitable semiconductor material, such as silicon, germanium, gallium arsenide, gallium nitride, and the like. The semiconductor die 104 of the semiconductor wafer 102 may include any of digital circuits, analog circuits, RF circuits, power circuits, sensors, memory, processor, the like, and combinations thereof.

FIG. 2 through FIG. 7 illustrate, in simplified cross-sectional views, the example semiconductor device 100 at stages of manufacture in accordance with an embodiment. The cross-sectional views depicted in FIG. 2 through FIG. 7 show a semiconductor die 104 separated from neighboring semiconductor die (portions) by way of singulation lanes 106, for example.

FIG. 2 illustrates, in a simplified cross-sectional view, the example semiconductor device 100 at a subsequent stage of manufacture in accordance with an embodiment. At this stage, the non-conductive layer 108 is affixed to the active side of the semiconductor wafer 102. In this embodiment, the non-conductive layer 108 is bonded to the final (outer-most) passivation layer 204 of the semiconductor wafer 102 during a heat treatment.

The semiconductor wafer 102 includes a semiconductor die 104 and portions of neighboring die as depicted in FIG. 2. The semiconductor die 104 includes the final passivation layer 204 with openings over bond pads 202 formed at the active side of the semiconductor die. Features of the semiconductor die 104 such as underlying passivation layers, interconnecting traces, and circuitry are not shown for illustration purposes. The openings in the final passivation layer 204 over the bond pads 202 are covered by the non-conductive layer 108.

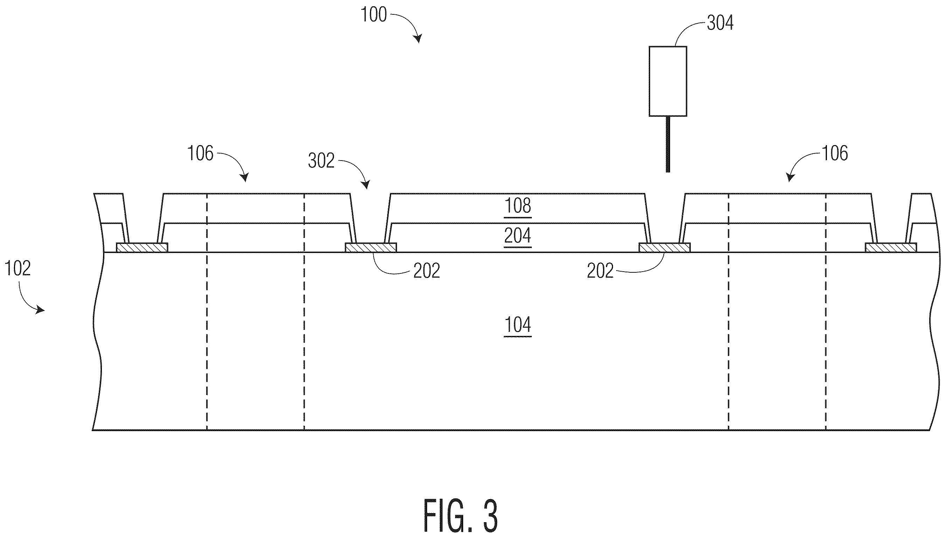

FIG. 3 illustrates, in a simplified cross-sectional view, the example semiconductor device 100 at a subsequent stage of manufacture in accordance with an embodiment. At this stage, openings (e.g., holes) 302 are formed through the non-conductive layer 108 to expose top surface portions of the bond pads 202. The openings may be formed by way of laser drilling using a laser apparatus 304, for example. In this embodiment, the exposed top surface portions of the bond pads 202 are configured and arranged for interconnection with a package substrate applied at a subsequent stage of manufacture.

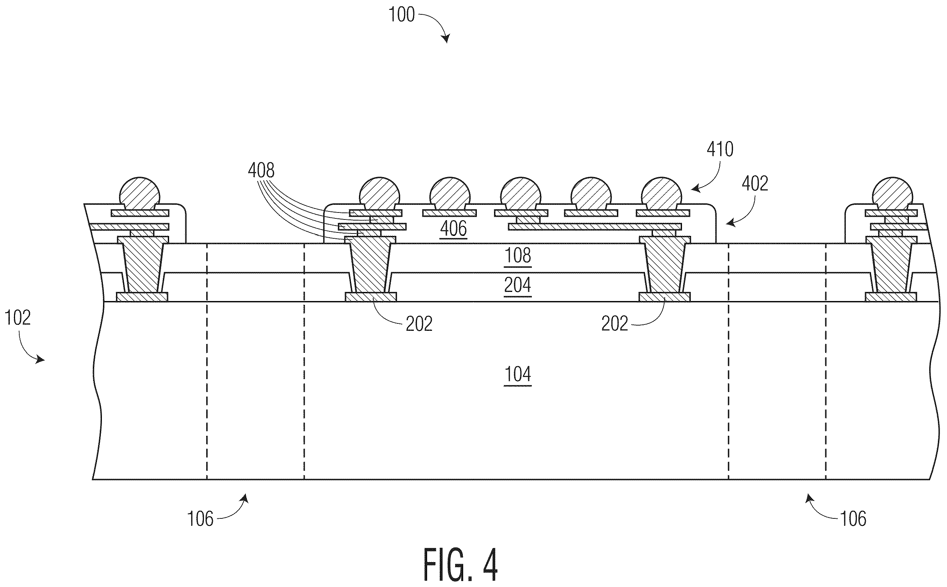

FIG. 4 illustrates, in a simplified cross-sectional view, the example semiconductor device 100 at a subsequent stage of manufacture in accordance with an embodiment. At this stage, a redistribution layer (RDL) structure 402 is applied over the non-conductive layer 108 and interconnected to the exposed top surface portions of bond pads 202 of the semiconductor die 104.

The RDL structure 402 includes conductive features 408 such as vias and traces surrounded by non-conductive material (e.g., dielectric) 406. In this embodiment, the conductive features 408 are formed from patterned metal (e.g., copper) layers separated by dielectric layers (406) of the RDL structure 402. Portions of the conductive features 408 are exposed at a bottom side of the RDL structure 402 and serve as conductive connector pads configured for attachment of conductive connectors 410, for example. The conductive features 408 are formed in the RDL structure 402 to interconnect the semiconductor die 104 (by way of the conductive connectors 410) with a printed circuit board (PCB), for example. In this embodiment, the RDL structure 402 is formed as a build-up package substrate directly on the non-conductive layer 108 and interconnected with the bond pads 202. In some embodiments, the RDL structure 402 may be provided as a pre-formed structure otherwise applied on the non-conductive layer 108 and interconnected with the bond pads 202.

In this embodiment, conductive connectors 410 (e.g., solder balls) are affixed to respective traces 408 exposed at the bottom side of the RDL structure 402. The conductive connectors 410 may be in the form of suitable conductive structures such as solder balls, gold studs, copper pillars, and the like, to connect conductive features of the semiconductor device 100 with the PCB.

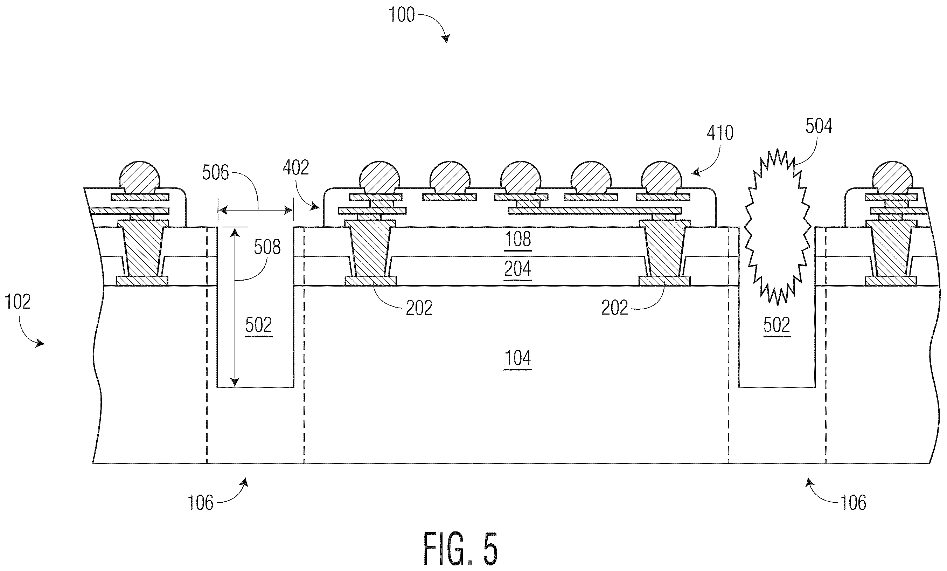

FIG. 5 illustrates, in a simplified cross-sectional view, the example semiconductor device 100 at a subsequent stage of manufacture in accordance with an embodiment. At this stage, a trench 502 is formed in the singulation lanes 106 surrounding the semiconductor die 104 of the semiconductor wafer 102. In this embodiment, the trench 502 is formed along each singulation lane 106 of semiconductor wafer. The trench 502 cut may be formed by way of a mechanical saw operation using mechanical saw apparatus 504, for example. In this embodiment, the trench 502 is formed having a predetermined width dimension 506 and a predetermined depth dimension 508. The trench 502 may also be referred to as a "half-cut" trench as the depth of the trench 502 may be formed to the depth dimension 508 roughly equal to half of the thickness of the semiconductor wafer 102.

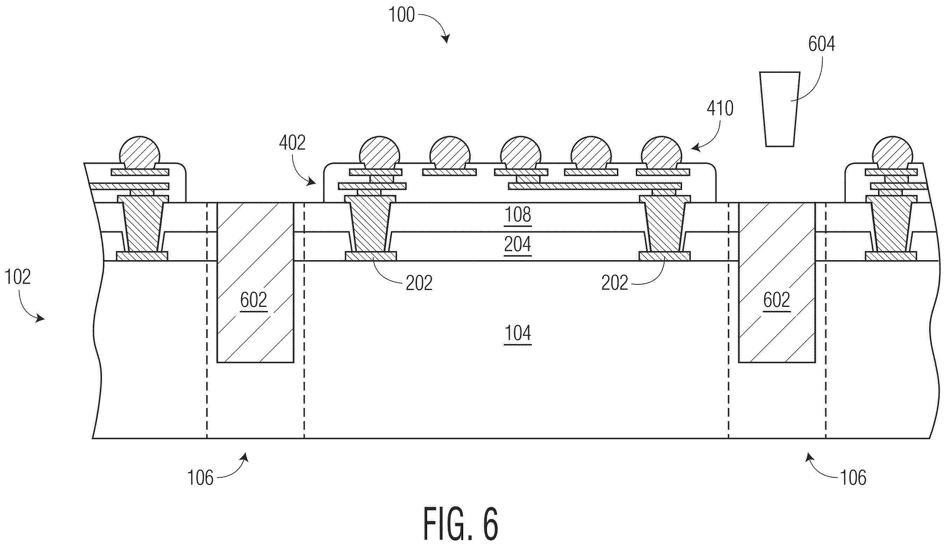

FIG. 6 illustrates, in a simplified cross-sectional view, the example semiconductor device 100 at a subsequent stage of manufacture in accordance with an embodiment. At this stage, the trench 502 of FIG. 5 is filled with a non-conductive filler 602. In this embodiment, a top surface of the non-conductive filler 602 may be substantially coplanar with a top surface of the non-conductive layer 108. The non-conductive filler 602 may be formed from an epoxy compound or glass material, for example. In this embodiment, the trench 502 is filled with the non-conductive filler 602 material by way of a jet dispensing process using a jet dispensing apparatus 604.

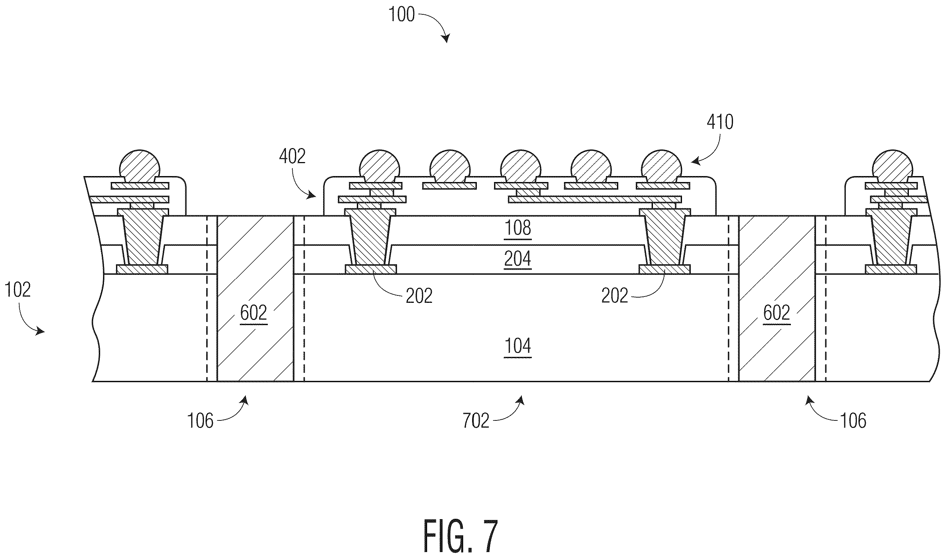

FIG. 7 illustrates, in a simplified cross-sectional view, the example semiconductor device 100 at a subsequent stage of manufacture in accordance with an embodiment. At this stage, the semiconductor wafer 102 is thinned from the backside to reveal a bottom surface of the non-conductive filler 602. After filling the trench 502 of FIG. 5 with the non-conductive filler 602, the bottom major side of the semiconductor wafer 102 is subjected to a grind operation to expose the bottom surface of the non-conductive filler 602 through the wafer.

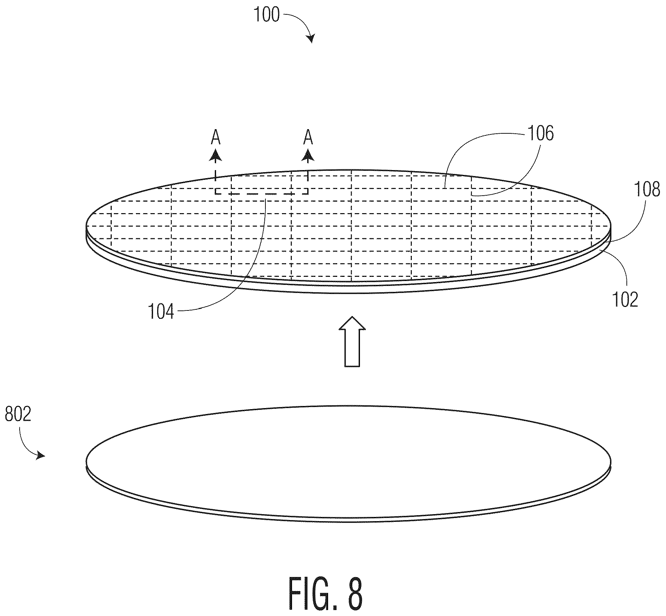

FIG. 8 illustrates, in simplified dimensional view, the example wafer-level chip-scale semiconductor device 100 at a subsequent stage of manufacture in accordance with an embodiment. At this stage, a second non-conductive layer 802 is positioned over the backside of the semiconductor wafer 102. The second non-conductive layer 802 is formed from a different material than that of the first non-conductive layer 108 in this embodiment. The non-conductive layer 802 may be provided as a preformed film such as an epoxy compound film, for example. In this embodiment, the semiconductor wafer 102 is arranged in an active-side-up orientation and configured for the non-conductive layer 108 to be bonded at the backside during a subsequent stage of manufacture.

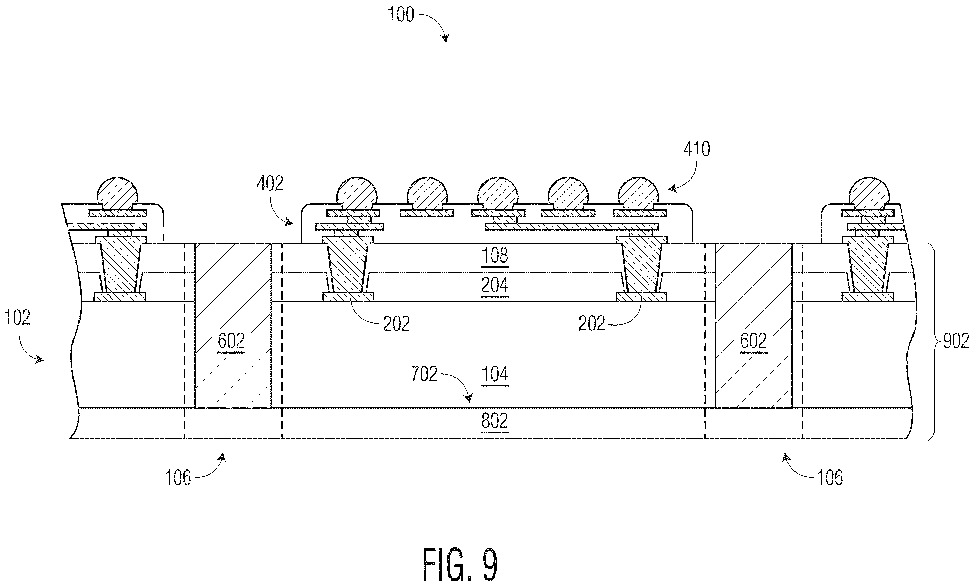

FIG. 9 illustrates, in a simplified cross-sectional view, the example semiconductor device 100 at a subsequent stage of manufacture in accordance with an embodiment. At this stage, the non-conductive layer 802 is affixed to the backside of the semiconductor wafer 102. In this embodiment, the non-conductive layer 802 is bonded to the ground backside of the semiconductor wafer 102 during a heat treatment. In this embodiment, a sandwich-like structure 902 is formed with the semiconductor wafer 102 sandwiched between the non-conductive layer 802 bonded to the backside of the semiconductor wafer 102 and the non-conductive layer 108 bonded to the active side of the semiconductor wafer 102. With the sandwich-like structure 902, the non-conductive layer 802 serves as a backside protection layer of the semiconductor die 104 of the semiconductor wafer 102 and the non-conductive layer 108 serves as a topside protection layer of the semiconductor die 104 of the semiconductor wafer 102. The term "protection" as used herein generally refers to protection of the semiconductor die from mechanical damage (e.g., chipping, cracks) and environmental hazards (e.g., moisture, contaminants).

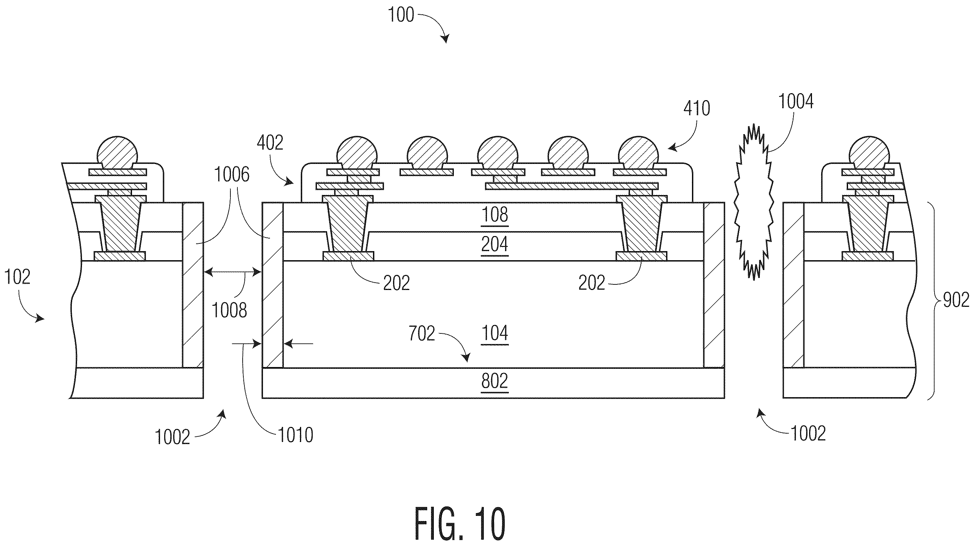

FIG. 10 illustrates, in a simplified cross-sectional view, the example semiconductor device 100 at a subsequent stage of manufacture in accordance with an embodiment. At this stage, the sandwich-like structure 902 including the semiconductor wafer 102 sandwiched between the non-conductive layer 802 and the non-conductive layer 108 is singulated during a singulation operation to form a plurality of individual semiconductor device 100 units. In this embodiment, a singulation cut 1002 is formed along singulation lanes 106 of FIG. 9 to singulate the sandwich-like structure 902 and form the individual semiconductor devices 100.

The singulation cut 1002 may be formed by way of a mechanical saw operation using mechanical saw apparatus 1004, for example. In this embodiment, the singulation cut 1002 is formed having a predetermined width dimension 1008. The width dimension 1008 of the singulation cut 1002 is configured to be narrower than the width dimension 506 of the trench 502 such that a predetermined filler coating portion 1006 of the non-conductive filler 602 having a predetermined coating thickness 1010 remains on the sidewalls of the semiconductor die 104 and overlaps a sidewall portion of the first non-conductive layer 108 after singulation. For example, it may be desirable to retain a minimum thickness (in a range of 10-30% of the width dimension 506) of the filler coating portion 1006 on each sidewall of the semiconductor die 104 after singulation to provide sufficient sidewall protection. In this embodiment, the predetermined thickness 1010 of the filler coating portion 1006 remaining on the sidewalls after singulation is approximately 10 microns or greater.

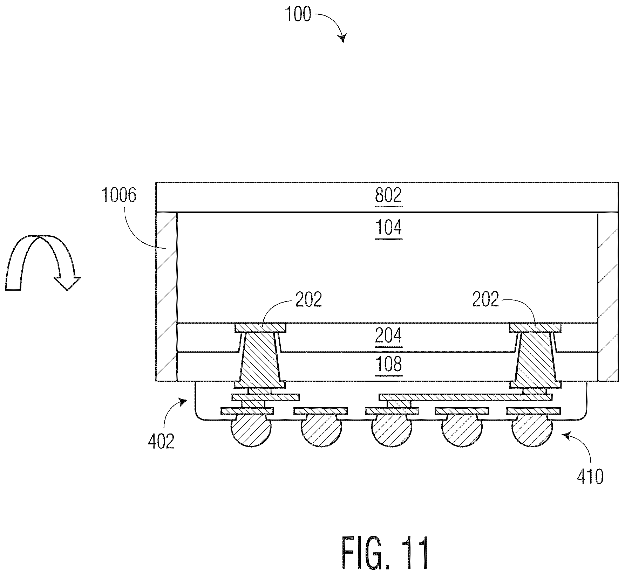

FIG. 11 illustrates, in a simplified cross-sectional view, the example semiconductor device 100 at the stage of manufacture depicted in FIG. 10 in accordance with an embodiment. As depicted in FIG. 11, the singulated semiconductor device 100 is reoriented (e.g., flipped) such that the semiconductor die 104 is in an active-side-down orientation. In this embodiment, the semiconductor device 100 is configured to provide six-sided protection for the semiconductor die 104. For example, the semiconductor device 100 includes the non-conductive layers 108 and 802 protecting the active side and backside of the semiconductor die 104 respectively, and the filler coating portion 1006 protecting the four sidewalls of the semiconductor die 104.

In this embodiment, the filler coating portion 1006 may be formed from a non-conductive material such as an epoxy compound or a glass material. When the filler coating portion 1006 is formed from a glass material, for example, the glass material is transparent allowing inspection of the semiconductor die sidewalls through the filler coating portion 1006. By forming the semiconductor device 100 in this manner, a thin, low-cost, wafer-level chip-scale semiconductor device having six-sided die protection may be realized.

Generally, there is provided, a method including applying a first non-conductive layer onto an active side of a semiconductor wafer, the semiconductor wafer including a plurality of semiconductor die surrounded by singulation lanes; forming a trench in the singulation lanes surrounding the semiconductor die; filling the trench with a non-conductive filler; grinding a backside of the semiconductor wafer to expose the non-conductive filler through the backside of the semiconductor wafer; applying a second non-conductive layer onto the backside of the semiconductor wafer; and forming a singulation cut through a portion of the non-conductive filler to form a plurality of individual packaged semiconductor device units, a predetermined portion of the non-conductive filler remaining on each sidewall of the plurality of semiconductor die. The method may further include forming openings through the first non-conductive layer to expose top surface portions of bond pads of the semiconductor die. The method may further include forming a redistribution layer (RDL) structure over the first non-conductive layer, the RDL structure interconnected to the exposed top surface portions of bond pads of the semiconductor die. The forming the trench may include sawing, by way of a mechanical blade, from the active side of the wafer and to a predetermined depth. The filling the trench with the non-conductive filler may include filling the trench with a glass material by way of a jet dispensing process. A width dimension of the singulation cut may be less than a width dimension of the trench. A thickness of the predetermined portion of the non-conductive filler remaining on each sidewall of the plurality of semiconductor die may be in a range of 10-30% of the width dimension of the trench. The first non-conductive layer and the second non-conductive layer together with the predetermined portion of the non-conductive filler remaining on semiconductor die sidewalls may be configured and arranged to provide six-sided protection for each of the individual packaged semiconductor device units. The first non-conductive layer may be formed from a material different from that of the second non-conductive layer.

In another embodiment, there is provided, a semiconductor device including a semiconductor die having a plurality of bond pads; a first non-conductive layer applied on an active side of the semiconductor die; openings formed through the first non-conductive layer, the openings configured to expose top surface portions of the bond pads; a second non-conductive layer applied on backside of the semiconductor die; and a non-conductive sidewall material formed on each sidewall of the semiconductor die. The first non-conductive layer and the second non-conductive layer together with the non-conductive sidewall material may be configured and arranged to provide six-sided protection for the semiconductor device. The semiconductor device may further include a redistribution layer (RDL) structure formed over the first non-conductive layer, the RDL structure interconnected to the exposed top surface portions of bond pads of the semiconductor die. A portion of the non-conductive sidewall material may overlap a sidewall portion of the first non-conductive layer. The non-conductive sidewall material may be characterized as a glass material. The first non-conductive layer may be characterized as a dry film.

In yet another embodiment, there is provided, a method including applying a first non-conductive layer onto an active side of a semiconductor wafer, the semiconductor wafer including a plurality of semiconductor die surrounded by singulation lanes; forming openings through the first non-conductive layer to expose top surface portions of bond pads of the semiconductor die; forming a trench in the singulation lanes surrounding the semiconductor die, the trench formed from the active side of the semiconductor wafer; filling the trench with a non-conductive filler; grinding a backside of the semiconductor wafer to expose the non-conductive filler through the backside of the semiconductor wafer; applying a second non-conductive layer onto the backside of the semiconductor wafer; and forming a singulation cut through a portion of the non-conductive filler to form a plurality of individual packaged semiconductor device units, a predetermined portion of the non-conductive filler remaining on each sidewall of the plurality of semiconductor die. The method may further include forming a redistribution layer (RDL) structure over the first non-conductive layer, the RDL structure interconnected to the exposed top surface portions of bond pads of the semiconductor die. The forming the trench may include sawing, by way of a mechanical blade, from the active side of the wafer and to a predetermined depth. The method of claim 16, wherein filling the trench with the non-conductive filler may include filling the trench with a glass material by way of a jet dispensing process. The method of claim 16, wherein a thickness of the predetermined portion of the non-conductive filler remaining on each sidewall of the plurality of semiconductor die may be in a range of 10-30% of a width dimension of the trench.

By now, it should be appreciated that there has been provided a wafer-level chip-scale semiconductor device having six-sided die protection. A first non-conductive layer is bonded on an active side of a semiconductor wafer containing a plurality of die surrounded by singulation lanes. A redistribution structure is formed over the first non-conductive layer and interconnected with bond pads of the die through openings formed in the first non-conductive layer. A continuous trench is formed along the singulation lanes such that each die is surrounded by the trench. The trench is subsequently filled with a filler material such as an epoxy compound or glass material. After the trench is filled, the backside of the semiconductor wafer is subjected to a grind operation to reduce the wafer thickness and expose the filler material through the backside of the wafer. A second non-conductive layer is bonded on the ground backside of the semiconductor wafer and exposed filler surface. A sandwich-like structure is formed with the semiconductor wafer sandwiched between the first non-conductive layer and the second non-conductive layer. After the second non-conductive layer is bonded on the backside of the semiconductor wafer, the sandwich-like structure is singulated to form a plurality of individual semiconductor device units. The singulation cut is formed having a width narrower than the width of the trench such that a filler coating portion remains on the sidewalls of each die after singulation. By forming the semiconductor device in this manner, a substantially thin, low-cost semiconductor device having six-sided die protection may be realized.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
applying a first non-conductive layer onto an active side of a semiconductor wafer, the semiconductor wafer including a plurality of semiconductor die surrounded by singulation lanes;
forming a trench in the singulation lanes surrounding the semiconductor die;
filling the trench with a non-conductive filler;
grinding a backside of the semiconductor wafer to expose the non-conductive filler through the backside of the semiconductor wafer;
applying a second non-conductive layer onto the backside of the semiconductor wafer; and
forming a singulation cut through a portion of the non-conductive filler to form a plurality of individual packaged semiconductor device units, a predetermined portion of the non-conductive filler remaining on each sidewall of the plurality of semiconductor die.

2. The method of claim 1, further comprising forming openings through the first non-conductive layer to expose top surface portions of bond pads of the semiconductor die.

3. The method of claim 2, further comprising forming a redistribution layer (RDL) structure over the first non-conductive layer, the RDL structure interconnected to the exposed top surface portions of bond pads of the semiconductor die.

4. The method according to any preceding claim, wherein forming the trench includes sawing, by way of a mechanical blade, from the active side of the wafer and to a predetermined depth.

5. The method according to any preceding claim, wherein filling the trench with the non-conductive filler includes filling the trench with a glass material by way of a jet dispensing process.

6. The method according to any preceding claim , wherein a width dimension of the singulation cut is less than a width dimension of the trench.

7. The method of claim 6, wherein a thickness of the predetermined portion of the non-conductive filler remaining on each sidewall of the plurality of semiconductor die is in a range of 10-30% of the width dimension of the trench.

8. The method according to any preceding claim, wherein the first non-conductive layer and the second non-conductive layer together with the predetermined portion of the non-conductive filler remaining on semiconductor die sidewalls are configured and arranged to provide six-sided protection for each of the individual packaged semiconductor device units.

9. The method according to any preceding claim, wherein the first non-conductive layer is formed from a material different from that of the second non-conductive layer.

10. A semiconductor device comprising:
a semiconductor die having a plurality of bond pads;
a first non-conductive layer applied on an active side of the semiconductor die;
openings formed through the first non-conductive layer, the openings configured to expose top surface portions of the bond pads;
a second non-conductive layer applied on backside of the semiconductor die; and
a non-conductive sidewall material formed on each sidewall of the semiconductor die.

11. The semiconductor device of claim 10, wherein the first non-conductive layer and the second non-conductive layer together with the non-conductive sidewall material are configured and arranged to provide six-sided protection for the semiconductor device.

12. The semiconductor device of claim 10 or claim 11, further comprising a redistribution layer (RDL) structure formed over the first non-conductive layer, the RDL structure interconnected to the exposed top surface portions of bond pads of the semiconductor die.

13. The semiconductor device according to any of claim 10 to claim 12, wherein a portion of the non-conductive sidewall material overlaps a sidewall portion of the first non-conductive layer.

14. The semiconductor device according to any of claim 10 to claim 13, wherein the non-conductive sidewall material is characterized as a glass material.

15. The semiconductor device according to any of claim 10 to claim 14, wherein the first non-conductive layer is characterized as a dry film.
